# EUROPEAN PATENT APPLICATION

(11) **EP 4 307 382 A1**
(43) Date of publication of application: **17.01.2024**
(21) Application number: 21930302.1
(22) Date of filing: 05.11.2021
(51) Int. Cl.: H01L 29/06, H01L 29/78, H01L 29/12, H01L 21/336

(54) **FIELD-EFFECT TRANSISTOR, AND METHOD FOR MANUFACTURING SAME**

(30) Priority: 11.03.2021 JP 2021039221; 15.04.2021 JP 2021069123; 23.06.2021 JP 2021103917
(71) Applicant: DENSO CORPORATION, Kariya-city, Aichi-pref., 448-8661 (JP)
(72) Inventor: TAKAYA, Hidefumi, Kariya-city, Aichi-pref., 448-8661 (JP)
(74) Representative: Winter, Brandl - Partnerschaft mbB
(86) International application number: PCT/JP2021/040836
(87) International publication number: WO 2022/190456

(57) **Abstract**

Afield effect transistor 10 includes a p-type trench lower layer 35, multiple p-type deep layers 36, and multiple n-type deep layers 37. The p-type trench lower layer is located below the trench 14, and extends in a longitudinal direction of the trench in a top view of a semiconductor substrate 12. Each of the p-type deep layers protrudes downward from a body layer 34, and extends in a first direction intersecting the trench in the top view of the semiconductor substrate. The p-type deep layers are spaced at intervals in a second direction perpendicular to the first direction, and are in contact with the p-type trench lower layer located below the trench. Each of the n-type deep layers is located in corresponding one of the intervals, and is in contact with a gate insulating film at a side surface of the trench located below the body layer.

## Description

### CROSS REFERENCE TO RELATED APPLICATIONS

The present application is based on Japanese Patent Application No. 2021-0039221 filed on March 11, 2021, Japanese Patent Application No. 2021-069123 filed on April 15, 2021, and Japanese Patent Application No. 2021-103917 filed on June 23, 2021, the contents of which are incorporated herein by reference.

### TECHNICAL FIELD

The present disclosure relates to a field effect transistor, and relates to a method of manufacturing the field effect transistor.

### BACKGROUND ART

JP 2009-194065A discloses a trench gate type field effect transistor. The field effect transistor includes multiple p-type deep layers protruding downward from a body layer. Each of the p-type deep layers extends so as to intersect trenches when a sem iconductor substrate is viewed from above. The p-type deep layers are arranged at intervals in a width direction of the p-type deep layers. Each of the p-type deep layers extends from the body layer to a position deeper than a bottom surface of each of the trenches. Each of the p-type deep layers is in contact with a gate insulating film at a side surface of each of the trenches and the bottom surface of each of the trenches located below the body layer in an example of the trench gate type field effect transistor disclosed in JP 2009-194065 A. The field effect transistor includes an n-type drift layer in contact with the body layer and each of the p-type deep layers. When the field effect transistor is turned off, a depletion layer spreads from the body layer into the drift layer. The source-drain voltage is held by the depletion layer extending into the drift layer. When the field effect transistor is turned off, a depletion layer also spreads from each of the p-type deep layers into the drift layer. Since each of the p-type deep layers is in contact with the gate insulating film at the bottom surface of each of the trenches, the drift layer around the bottom surface of each of the trenches is depleted by the depletion layer spreading from each of the p-type deep layers. In this manner, the depletion layer extending from each of the p-type deep layers to the periphery of the bottom surface of each of the trenches restricts the occurrence of electric field concentration in the gate insulating film and the drift layer in the vicinity of the bottom surface of each of the trenches. Therefore, the above-described field effect transistor can have a high breakdown voltage.

### SUMMARY OF INVENTION

It is required to provide technology for further relieving electric field concentration at a gate insulating film around the bottom surface of a trench and enhancing a breakdown voltage in a field effect transistor having multiple p-type deep layers. The present specification proposes technology for achieving a high breakdown voltage in a field effect transistor having multiple p-type deep layers.

A field effect transistor disclosed in the present specification includes a semiconductor substrate having a trench on an upper surface thereof, a gate insulating film covering an inner surface of the trench, and a gate electrode disposed in the trench and being insulated from the semiconductor substrate by the gate insulating film. The semiconductor substrate includes an n-type source layer, a p-type body layer, a p-type trench lower layer, multiple p-type deep layer, and multiple n-type deep layers. The source layer is in contact with the gate insulating film at a side surface of the trench. The body layer is in contact with the gate insulating film at the side surface of the trench located below the source layer. The trench lower layer is located below the trench, and extends in a longitudinal direction in a top view of the semiconductor substrate. Each of the p-type deep layers protrudes downward from the body layer and extends from the body layer to a position below a bottom surface of the trench. Each of the p-type deep layers extends in a first direction intersecting the trench in a top view of the semiconductor substrate. The p-type deep layers are spaced at intervals in a second direction orthogonal to the first direction in a top view of the semiconductor substrate, and is in contact with the trench lower layer located below the trench. Each of the multiple n-type deep layers is disposed in corresponding one of the intervals and is in contact with the gate insulating film on the side surface of the trench located below the body layer.

The field effect transistor has the p-type trench lower layer located below the trench. Therefore, the electric field concentration around the bottom surface of the trench is relaxed when the field effect transistor is turned off. As a result, this field effect transistor can have a high breakdown voltage. Furthermore, in this field effect transistor, the p-type trench lower layer is electrically connected to the body layer through the multiple p-type deep layers. Therefore, the potential of the p-type trench lower layer is stabilized, and deterioration of the switching characteristics of the field effect transistor is suppressed. In the field effect transistor, it is possible to inhibit the deterioration of the switching characteristics while enhancing the breakdown voltage by the combination of the p-type trench lower layer and the multiple deep layers.

A method of manufacturing a field effect transistor disclosed in the present specification includes a deep layer forming process, a trench forming process, a body layer forming process, and a p-type trench lower layer forming process. The deep layer forming process includes formation of multiple p-type deep layers and multiple n-type deep layers at an n-type epitaxial layer. Each of the multiple p-type deep layers extends in a first direction in a top view of the epitaxial layer. The multiple p-type deep layers are spaced at intervals in a second direction perpendicular to the first direction in the top view of the epitaxial layer. The multiple n-type deep layers are correspondingly located in the intervals. The trench forming process includes formation of a trench having a depth from a surface of the epitaxial layer to a location not exceeding a depth of each of the multiple p-type deep layers and a depth of each of the multiple n-type deep layers. The trench intersects the multiple p-type deep layers and the multiple n-type deep layers in the top view of the epitaxial layer. The body layer forming process includes formation of a body layer above the multiple p-type deep layers and the multiple n-type deep layers through ion implantation introducing of p-type impurities toward a surface of the epitaxial layer. The p-type trench lower layer forming process includes formation of a p-type trench lower layer below a bottom surface of the trench through the ion implantation.

According to the method of manufacturing the field effect transistor, it is possible to manufacture the field effect transistor having the p-type trench lower layer and the multiple p-type deep layers.

### BRIEF DESCRIPTION OF DRAWINGS

FIG. 1 is a cross-sectional perspective view of the MOSFET 10 (diagram showing an xz cross section excluding the p-type deep layers 36).
FIG. 2 is a cross-sectional perspective view of the MOSFET 10 omitting the source electrode 22 and the interlayer insulating film 20 (diagram showing the xz cross section excluding the p-type deep layers 36).
FIG. 3 is an enlarged xy cross-sectional view including a p-type trench lower layer 35, the p-type deep layers 36 and n-type deep layers 37, and is an enlarged cross-sectional view of the MOSFET 10 illustrating the arrangement of the p-type trench lower layer 35, the p-type deep layers 36 and the n-type deep layers 37 in a top view of the semiconductor substrate 12.
FIG. 4 is an enlarged xy cross-sectional view including a trench 14, the p-type deep layers 36 and n-type deep layers 37, and is an enlarged cross-sectional view of the MOSFET 10 illustrating the arrangement of the trench 14, the p-type deep layers 36 and the n-type deep layers 37 in a top view of the semiconductor substrate 12.
FIG. 5 is an enlarged yz cross-sectional view of the MOSFET 10 including the p-type deep layers 36 and the n-type deep layers 37.
FIG. 6 is a cross-sectional perspective view of the MOSFET 10 (diagram showing an xz cross section including the p-type deep layers 36).
FIG. 7 is an enlarged xy cross-sectional view including the trench 14, the p-type deep layers 36 and the n-type deep layers 37, and is an enlarged cross-sectional view of a modified example of the MOSFET 10 illustrating the arrangement of the trench 14, the p-type deep layers 36 and the n-type deep layers 37 in the top view of the semiconductor substrate 12.
FIG. 8 is an enlarged xy cross-sectional view including the trench 14, the p-type deep layers 36 and the n-type deep layers 37, and is an enlarged cross-sectional view of a modified example of the MOSFET 10 illustrating the arrangement of the trench 14, the p-type deep layers 36 and the n-type deep layers 37 in the top view of the semiconductor substrate 12.
FIG. 9 is an enlarged xy cross-sectional view including the p-type trench lower layer 35, the p-type deep layers 36 and n-type deep layers 37, and is an enlarged cross-sectional view of a modified example of the MOSFET 10 illustrating the arrangement of the p-type trench lower layer 35, the p-type deep layers 36 and the n-type deep layers 37 in the top view of the semiconductor substrate 12.
FIG. 10 is a cross-sectional perspective view of a modified example of the MOSFET 10 omitting the source electrode 22 and the interlayer insulating film 20 (diagram showing the xz cross section excluding the p-type deep layers 36).
FIG. 11 is a cross-sectional perspective view of a modified example of the MOSFET 10 (diagram showing the xz cross section excluding the p-type deep layers 36).
FIG. 12 is a cross-sectional perspective view of a modified example of the MOSFET 10 (diagram showing an xz cross section including the p-type deep layers 36).
FIG. 13 is a cross-sectional perspective view of a modified example of the MOSFET 10 (diagram showing the xz cross section excluding the p-type deep layers 36).
FIG. 14 is a cross-sectional perspective view of a modified example of the MOSFET 10 (diagram showing the xz cross section including the p-type deep layers 36).
FIG. 15 is an explanatory diagram of a manufacturing method of the MOSFET 10.
FIG. 16 is an explanatory diagram of a manufacturing method of the MOSFET 10.
FIG. 17 is an explanatory diagram of a manufacturing method of the MOSFET 10.
FIG. 18 is an explanatory diagram of a manufacturing method of the MOSFET 10.
FIG. 19 is an explanatory diagram of a manufacturing method of the MOSFET 10.
FIG. 20 is a cross-sectional perspective view of a modified example of the MOSFET 10 (diagram showing the xz cross section excluding the p-type deep layers 36).

### DETAILED DESCRIPTION OF EMBODIMENTS

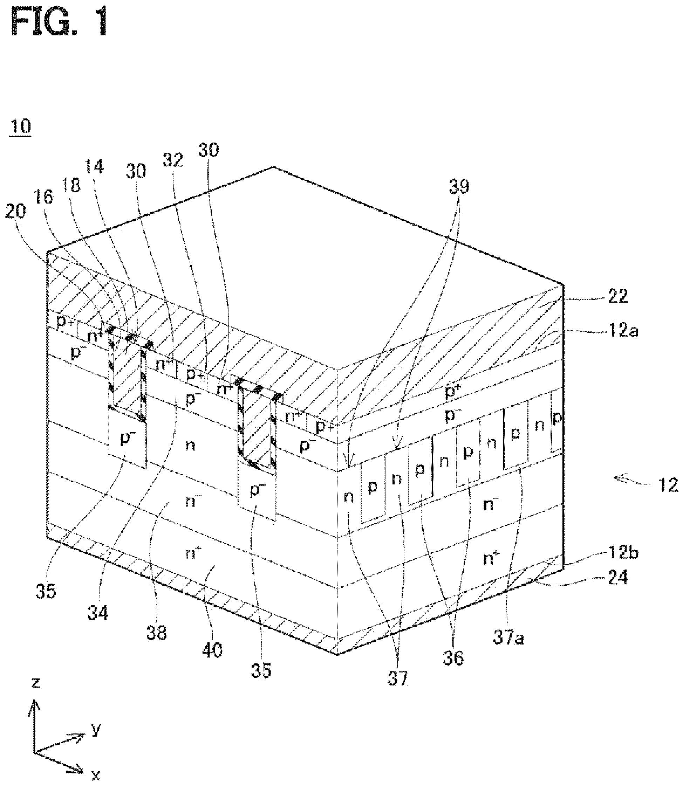

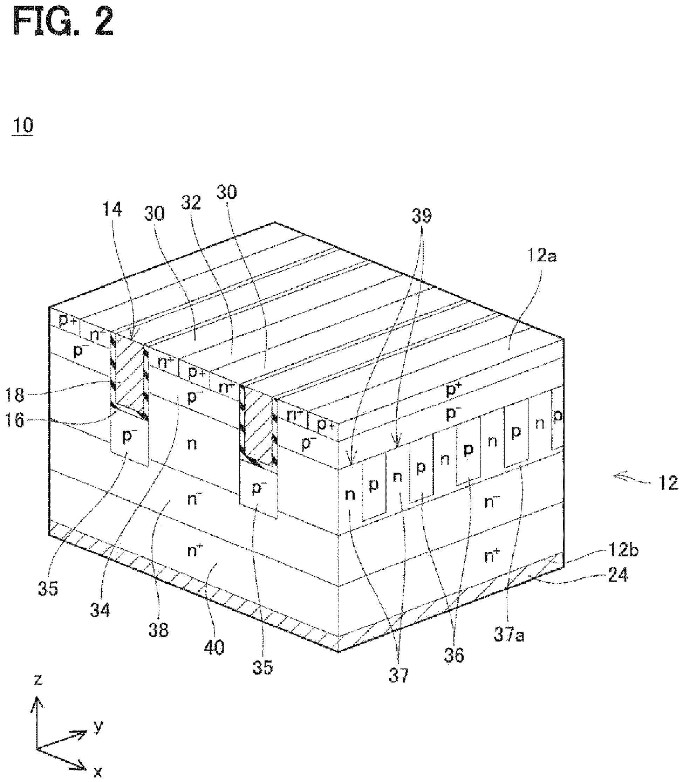

A metal-oxide-semiconductor field effect transistor (MOSFET) 10 of an embodiment shown in FIG. 1 and FIG. 2 includes a semiconductor substrate 12. In the following, a direction parallel to an upper surface 12a of the semiconductor substrate 12 may also be referred to as an x-direction being perpendicular to a z-direction, a thickness direction of the semiconductor substrate 12 may also be referred to as the z-direction, and a direction perpendicular to the x-direction and the z-direction may also be referred to as a y-direction. The semiconductor substrate 12 is made of silicon carbide (SiC). However, the semiconductor substrate 12 may also be made of other material such as silicon or gallium nitride. Multiple trenches 14 are provided from the upper surface 12a of the semiconductor substrate 12. As shown in FIG. 2, the trenches 14 extend in the y-direction on the upper surface 12a. The trenches 14 are arranged at intervals in the x-direction.

As shown in FIG. 1 and FIG. 2, an inner surface (that is, a bottom surface and a side surface) of each of the trenches 14 is covered with a gate insulation film 16. A gate electrode 18 is disposed in each of the trenches 14. The gate electrode 18 is insulated from the semiconductor substrate 12 by the gate insulation film 16. As shown in FIG. 1, an upper surface of the gate electrode 18 is covered with an interlayer insulation film 20. A source electrode 22 is disposed on the semiconductor substrate 12. The source electrode 22 covers each of the interlayer insulation films 20. The source electrode 22 is insulated from the gate electrodes 18 by the interlayer insulation films 20. The source electrode 22 is in contact with the upper surface 12a of the semiconductor substrate 12 at portions where the interlayer insulation films 20 are not provided. A drain electrode 24 is disposed at a bottom of the semiconductor substrate 12. The drain electrode 24 is in contact with the entire region of a lower surface 12b of the semiconductor substrate 12.

As shown in FIG. 1 and FIG. 2, the semiconductor substrate 12 includes multiple source layers 30, multiple contact layers 32, a body layer 34, multiple p-type trench lower layers 35, multiple p-type deep layers 36, multiple n-type deep layers 37, a drift layer 38, and a drain layer 40.

Each of the source layers 30 is an n-type layer having a high n-type impurity concentration. Each of the source layers 30 is disposed in a range partially including the upper surface 12a of the semiconductor substrate 12. Each of the source layers 30 is in ohmic contact with the source electrode 22. Each of the source layers 30 is in contact with the gate insulating film 16 at an uppermost portion of the side surface of the trench 14. Each of the source layers 30 faces the gate electrode 18 with the gate insulating film 16 interposed therebetween. Each of the source layers 30 extends in the y-direction along the side surface of the trench 14. Each of the source layers 30 extends in a direction parallel to the longitudinal direction of the trench 14 when the semiconductor substrate 12 is viewed from above, and extends from an end portion of the trench 14 to another end portion of the trench 14 in the longitudinal direction.

Each of the contact layers 32 is a p-type layer having a high p-type impurity concentration. Each of the contact layers 32 is disposed in a range partially including the upper surface 12a of the semiconductor substrate 12. Each of the contact layers 32 is disposed between two corresponding source layers 30. Each of the contact layers 32 is in ohmic contact with the source electrode 22. Each of the contact layers 32 extends in the y-direction. Each of the contact layers 32 extends in a direction parallel to the longitudinal direction of the trench 14 when the semiconductor substrate 12 is viewed from above, and extends from an end portion of the trench 14 to another end portion of the trench 14 in the longitudinal direction.

The body layer 34 is a p-type layer having a lower p-type impurity concentration than the contact layers 32. The body layer 34 is disposed below the source layers 30 and the contact layers 32. The body layer 34 is in contact with the source layers 30 and the contact layers 32 from below. The body layer 34 is in contact with the gate insulating film 16 on the side surface of the trench 14 located below the source layer 30. The body layer 34 faces the gate electrode 18 with the gate insulating film 16 interposed therebetween.

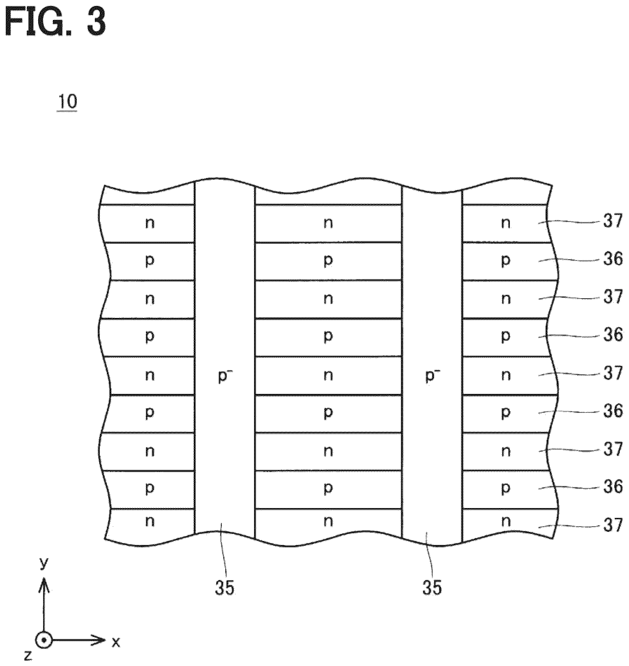

Each of the p-type trench lower layers 35 is a p-type layer disposed below the corresponding trench 14. As will be described later, each of the p-type trench lower layers 35 may be formed in an ion implantation process, which is also adopted in the formation of the body layer 34. In this case, the concentration profile of p-type impurities in the depth direction of each of the p-type trench lower layers 35 and the body layer 34 is consistent. The depth measured from the bottom surface of the corresponding trench 14 to the lower surface of each of the p-type trench lower layers 35 matches to the depth measured from the upper surface 12a of the semiconductor substrate 12 to the lower surface of the body layer 34. In this example, each of the p-type trench lower layers 35 is in contact with the gate insulating film 16 covering the bottom surface of the corresponding trench 14. As shown in FIG. 3, when the semiconductor substrate 12 is viewed from above, each of the p-type trench lower layers 35 may extend longer in the longitudinal direction of the corresponding trench 14 (the y-direction in this example), and may extend continuously from an end of the trench 14 to another end of the trench 14 in the longitudinal direction. As described hereinafter, each of the p-type trench lower layers 35 may extend longer in the longitudinal direction of the corresponding trench 14 (the y-direction in this example), and may be formed in several segments from an end of the trench 14 to another end of the trench 14 in the longitudinal direction.

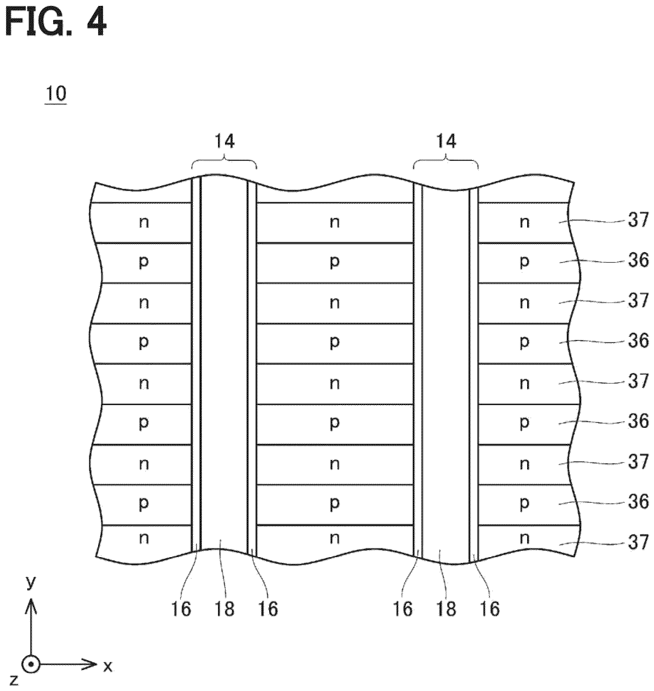

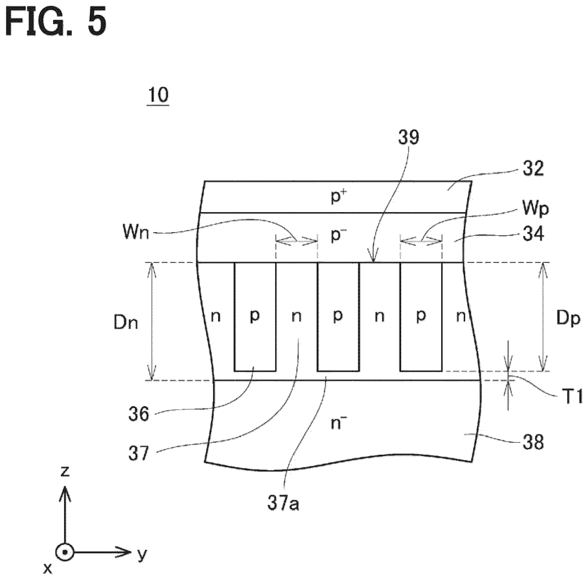

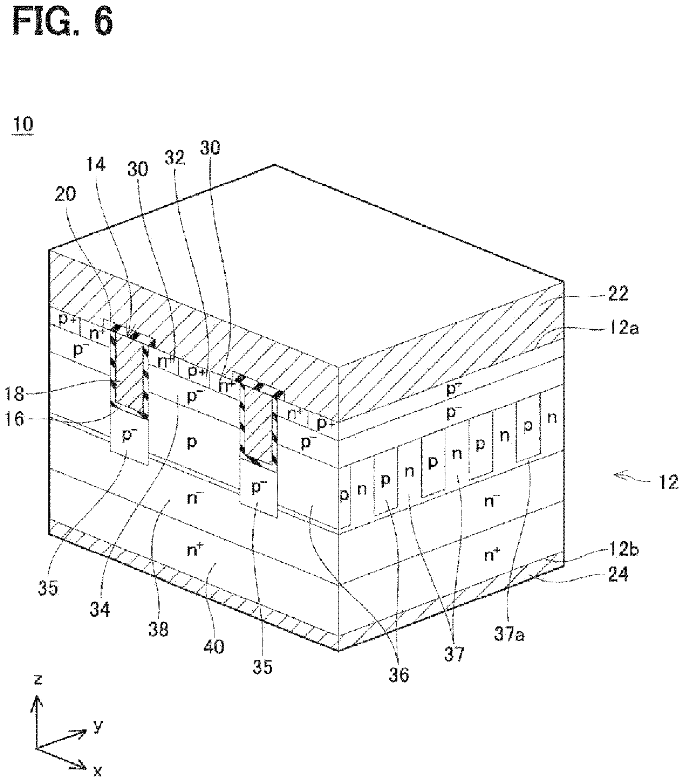

Each of the p-type deep layers 36 is a p-type layer protruding downward from the lower surface of the body layer 34. A p-type impurity concentration of each of the p-type deep layers 36 is higher than the p-type impurity concentration of the body layer 34 and lower than the p-type impurity concentration of the contact layer 32. As shown in FIG. 4, when the semiconductor substrate 12 is viewed from above, each of the p-type deep layers 36 extends in the x-direction and is orthogonal to the longitudinal direction (the y-direction in this example) of the trenches 14. The p-type deep layers 36 are arranged at intervals in the y-direction. Hereinafter, a portion between the p-type deep layers 36 is referred to as a spacing portion 39 (see FIGS. 1 and 2). As shown in FIG. 5, the p-type deep layers 36 have a shape elongated in the z-direction in the yz cross section. That is, a dimension of the p-type deep layers 36 in the z-direction (hereinafter, referred to as a depth Dp) is larger than a dimension of the p-type deep layers 36 in the y-direction (hereinafter, referred to as a width Wp). For example, the depth Dp can be set to 1 to 4 times the width Wp. As shown in FIG.6, each of the p-type deep layers 36 extends from the lower surface of the body layer 34 to a depth below the bottom surface of each of the trenches 14. Each of the p-type deep layers 36 is in contact with the gate insulating film 16 on the side surface of each of the trenches 14 located below the body layer 34. As shown in FIG. 3, each of the p-type deep layers 36 is in contact with the p-type trench lower layer 35 disposed below the trench 14 to as to intersect the p-type trench lower layer 35.

Each of the n-type deep layers 37 is an n-type layer having an n-type impurity concentration higher than that of the drift layer 38. The n-type impurity concentration of each of the n-type deep layers 37 is lower than the p-type impurity concentration of each of the p-type deep layers 36. Instead of this example, each of the n-type deep layers 37 may have the same concentration as the n-type impurity concentration of the drift layer 38. As shown in FIG. 1 and FIG. 2, each of the n-type deep layers 37 is disposed in a corresponding spacing portion 39. Each of the n-type deep layers 37 is in contact with the lower surface of the body layer 34. Each of the n-type deep layers 37 is in contact with the side surfaces of the p-type deep layer 36 on both sides thereof. Each of the n-type deep layers 37 extends from the lower surface of the body layer 34 to a depth below the bottom surface of each of the trenches 14 and the lower surface of each of the p-type deep layers 36. As shown in FIG. 5, each of the n-type deep layers 37 in the spacing portion 39 has a shape elongated in the z-direction in the yz cross section. That is, a dimension of each of the n-type deep layers 37 in the z-direction (hereinafter, referred to as a depth Dn) is larger than a dimension of each of the n-type deep layers 37 in the spacing portion 39 in the y-direction (hereinafter, referred to as a width Wn). For example, the depth Dn can be set to 1 to 4 times the width Wn. In the present embodiment, the width Wn of each of the n-type deep layers 37 is substantially equal to the width Wp of each of the p-type deep layers 36. Each of the n-type deep layers 37 has a connection region 37a extending directly below the lower surface of the adjacent p-type deep layer 36. Each of the connection regions 37a is in contact with the lower surface of the corresponding one of the p-type deep layers 36. The n-type deep layers 37 are connected to each other via the connection regions 37a. A thickness T1 of portions where the n-type deep layers 37 protrude below the lower surfaces of the p-type deep layers 36 (that is, a distance in the z-direction from the lower surfaces of the p-type deep layers 36 to the lower surfaces of the n-type deep layers 37) is about 0.1 µm, which is extremely thin. As illustrated in FIGS. 1 and 2, each of the n-type deep layers 37 is in contact with the gate insulating film 16 on the side surface of each of the trenches 14 located below the body layer 34 in each spacing portion 39. As shown in FIG. 3, each of the n-type deep layers 37 is in contact with the p-type trench lower layer 35 disposed below the trench 14 to as to intersect the p-type trench lower layer 35.

The drift layer 38 is an n-type layer having a lower n-type impurity concentration lower than each of the n-type deep layers 37. The drift layer 38 is disposed below the n-type deep layers 37. The drift layer 38 is in contact with the n-type deep layers 37 from below.

The drain layer 40 is an n-type layer having a higher n-type impurity concentration than the drift layer 38 and the n-type deep layers 37. The drain layer 40 is in contact with the drift layer 38 from below. The drain layer 40 is arranged in a region including a lower surface 12b of the semiconductor substrate 12. The drain layer 40 is in ohmic contact with the drain electrode 24.

The following describes an operation of the MOSFET 10. When the MOSFET 10 is used, a higher potential is applied to the drain electrode 24 as compared to the source electrode 22. When a potential equal to or higher than a gate threshold value is applied to each of the gate electrodes 18, a channel is formed in the body layer 34 in the vicinity of the gate insulating film 16. The source layers 30 and the n-type deep layers 37 are connected by the channel. Therefore, electrons flow from the source layer 30 to the drain layer 40 through the channel, the n-type deep layers 37, and the drift layer 38. That is, the MOSFET 10 is turned on. When the potential of each of the gate electrodes 18 is reduced from a value equal to or higher than the gate threshold value to a value less than the gate threshold value, the channel disappears and the flow of electrons stops. In other words, the MOSFET 10 is turned off.

Next, the operation when the MOSFET 10 is turned off will be described in more detail. When the channel disappears, a reverse voltage is applied to a pn junction at an interface between the body layer 34 and each of the n-type deep layers 37. Therefore, a depletion layer spreads from the body layer 34 to each of the n-type deep layers 37. Each of the p-type deep layers 36 is electrically connected to the body layer 34 and has substantially the same potential as the body layer 34. Therefore, when the channel disappears, a reverse voltage is also applied to a pn junction at an interface between each of the p-type deep layers 36 and each of the n-type deep layers 37. Therefore, a depletion layer also spreads from each of the p-type deep layers 36 to each of the n-type deep layers 37. Furthermore, each of the p-type trench lower layers 35 is electrically connected to the body layer 34 via each of the p-type deep layers 36, and has substantially the same potential as the body layer 34. Therefore, when the channel disappears, a reverse voltage is also applied to a pn junction at an interface between each of the p-type trench lower layers 35 and each of the n-type deep layers 37. Thus, each of the n-type deep layers 37 is quickly depleted by a depletion layer spreading from the body layer 34, each of the p-type trench lower layers 35 and each of the p-type deep layers 36. In particular, since each of the p-type trench lower layers 35 is provided under the corresponding trench 14, the periphery of the bottom surface of the trench 14 is well depleted. Accordingly, the electric field concentration in the vicinities of the bottom surfaces of the trenches 14 can be greatly relaxed. In addition, the entire portion of each of the n-type deep layers 37 is depleted by the depletion layers extending from the body layer 34, each of the p-type trench lower layers 35, and each of the p-type deep layers 36. Note that since each of the n-type deep layers 37 has the n-type impurity concentration higher than that of the drift layer 38, a depletion layer is less likely to spread in each of the n-type deep layers 37 than in the drift layer 38. Since each of the n-type deep layers 37 is sandwiched by the p-type deep layers 36 and the width Wn of each of the n-type deep layers 37 is short, the entire portion of each of the n-type deep layers 37 is depleted. The depletion layer spreads to the drift layer 38 through each of the n-type deep layers 37. Since the n-type impurity concentration of the drift layer 38 is low, almost the entire portion of the drift layer 38 is depleted. The high voltage applied between the drain electrode 24 and the source electrode 22 is held by the depleted drift layer 38 and each of the n-type deep layers 37. Therefore, the MOSFET 10 has a high breakdown voltage.

Also, in the MOSFET 10, the p-type trench lower layer 35 is electrically connected to the body layer 34 via the p-type deep layer 36. Therefore, the potential of the p-type trench lower layer is stabilized, and deterioration of the switching characteristics of the MOSFET 10 is suppressed. In the MOSFET 10, it is possible to inhibit the deterioration of the switching characteristics while enhancing the breakdown voltage by the combination of the p-type trench lower layer 35 and the p-type deep layer 36.

In the MOSFET 10, the p-type trench lower layer 35 is in contact with the gate insulating film 16 covering the bottom surface of the trench 14. As a result, the capacitance (that is, feedback capacitance) between the gate electrode 18 and the drain electrode 24 decreases. In addition, in the MOSFET 10 of the present embodiment, each of the n-type deep layers 37 and each of the p-type deep layers 36 have a vertically long shape. When each of the n-type deep layers 37 and each of the p-type deep layers 36 are configured as described above, the feedback capacitance decreases. Accordingly, the switching speed of the MOSFET 10 can be enhanced.

Also, in the MOSFET 10, the p-type trench lower layer 35 is deeper than the p-type deep layer 36 and the n-type deep layer 37. When such a deep p-type trench lower layer 35 is provided, the breakdown voltage of the MOSFET 10 is enhanced because the depletion of each of the n-type deep layer 37 and the drift layer 38 progresses. Further, when such a deep p-type trench lower layer 35 is provided, breakdown occurs in the p-type trench lower layer 35 protruding downward when an overvoltage is applied. Therefore, it is possible to reliably cause the breakdown in the cell region. As a result, the avalanche resistance of the MOSFET 10 can also be stabilized. The depth of the p-type trench lower layer 35 may be smaller than the depth of each of the p-type deep layer 36 and the n-type deep layer 37. In this case, since the depletion layer extending from the p-type trench lower layer 35 is suppressed, the on-resistance of the MOSFET 10 is enhanced.

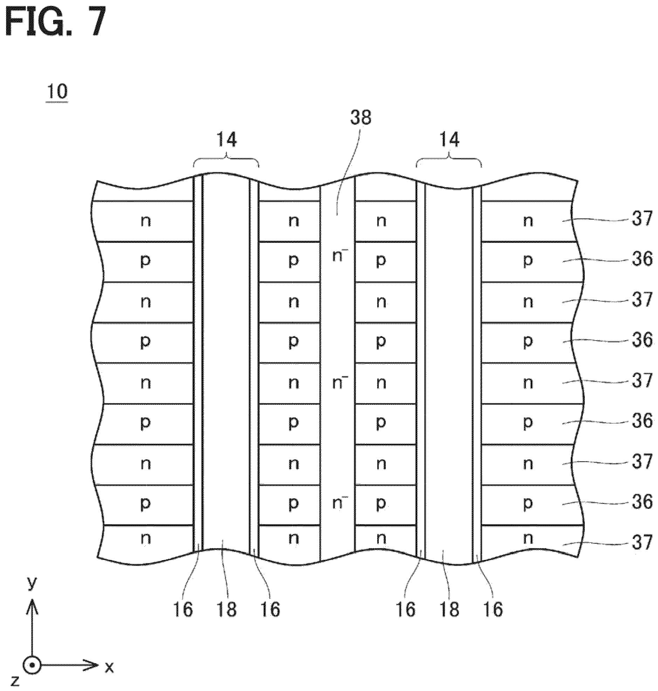

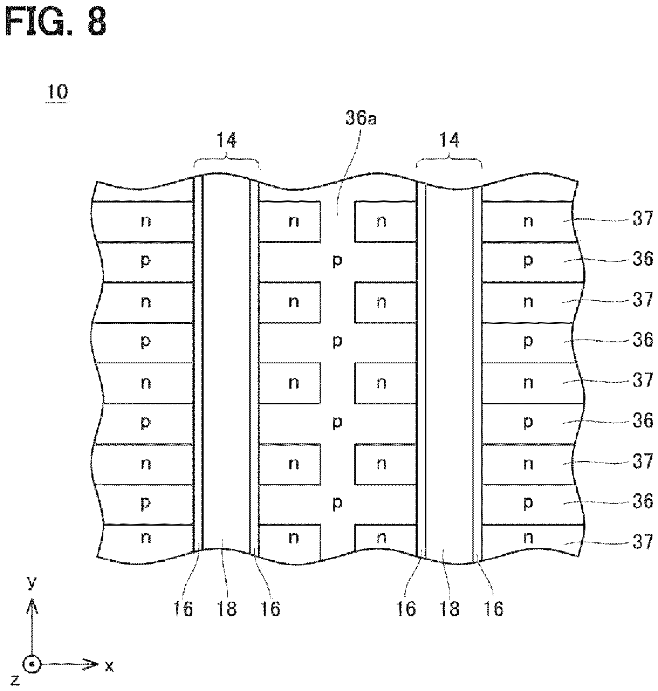

As shown in FIG. 4, in the MOSFET 10, when the semiconductor substrate 12 is viewed from above, each of the p-type deep layers 36 and each of the n-type deep layers 37 continuously extend in the x-direction between adjacent trenches 14. Instead of this example, as shown in FIG. 7, each of the p-type deep layers 36 and each of the n-type deep layers 37 may be divided into several sections in the x-direction. In this example, since each of the p-type deep layers 36 is provided in several sections, a wide current path is ensured and the on-resistance decreases. However, even in this example, each of the p-type deep layers 36 and each of the n-type deep layers 37 are arranged so as to straddle the trench 14. Thereby, the above-described effects can be exhibited. It is noted that only one of each p-type deep layer 36 and each n-type deep layer 37 may be divided into several sections in the x-direction. Further, as shown in FIG. 8, a connection p-layer 36a connecting the adjacent p-type deep layers 36 in the y-direction may be provided. Such a connection p-layer 36a is effective in relaxing the electric field applied to the gate insulating film 16 and enhancing the breakdown voltage.

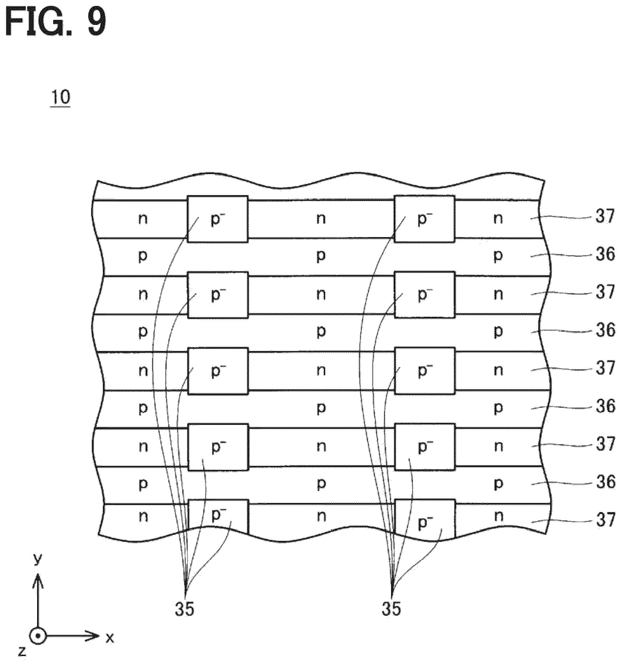

In the MOSFET 10, as shown in FIG. 3, when the semiconductor substrate 12 is viewed from above, each of the p-type trench lower layers 35 extends continuously from one end of the trench 14 to the other end of the trench 14 in the longitudinal direction. As shown in FIG. 9, when the semiconductor substrate 12 is viewed from above, each of the p-type trench lower layers 35 may extend longer in the longitudinal direction of the corresponding trench 14 (the y-direction in this example), and may be formed into several segments from one end of the trench 14 to the other end of the trench 14 in the longitudinal direction. In this case, each of the p-type deep layers 36 passes through a portion between corresponding adjacent two of the segments of the p-type trench lower layer 35. For example, in the example shown in FIG. 3, there is a concern about an increase in a damage at the portion where the p-type trench lower layer 35 and the p-type deep layer 36 overlap during ion implantation, and there is a concern about an increase in leakage current. On the other hand, in the example shown in FIG. 9, since the overlapping portion between the p-type trench lower layer 35 and the p-type deep layer 36 is small, an increase in leakage current can be suppressed.

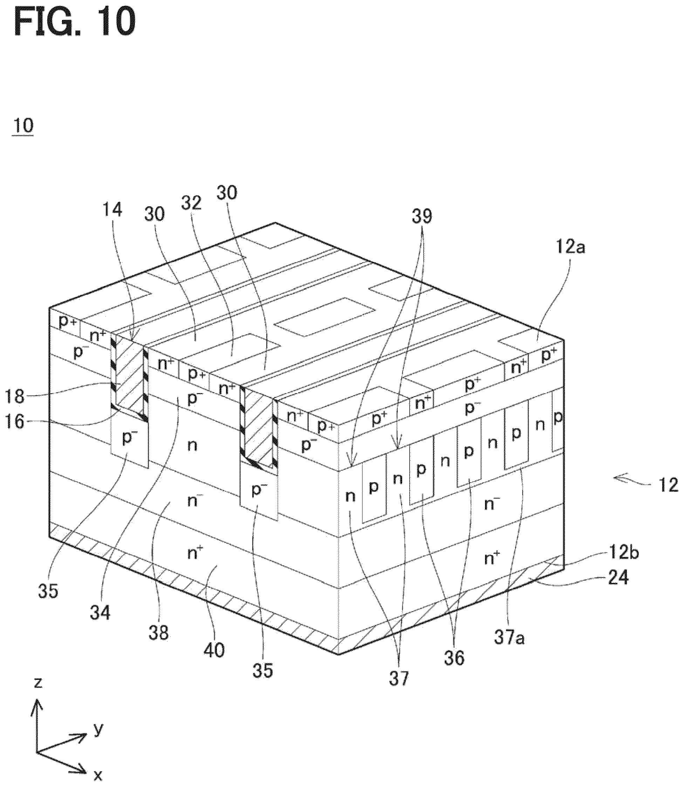

As shown in FIG. 2, in the MOSFET 10, when the semiconductor substrate 12 is viewed from above, each of the source layers 30 and each of the contact layers 32 extend in parallel to the longitudinal direction of the trench 14. In particular, each of the source layers 30 extend in parallel to the longitudinal direction of the trench 14 and is contact with the side surface of the trench 14, it is possible to adopt the entire side surface of the trench 14 as a high-concentration channel. Therefore, the on-resistance of the MOSFET 10 is low. Furthermore, since the entire side surface of the trench 14 can be used as a channel, the channel and each of the n-type deep layers 37 are well connected. For example, if each of the source layers 30 extends to intersect the longitudinal direction of the trench 14, particularly perpendicular to the longitudinal direction of the trench 14, the position of the source layer 30 adjacent to the side surface of the side surface of the trench 14 is limited. Therefore, the channel with high concentration formed at the side surface of the trench 14 is also limited. In such an example, due to misalignment in a positional relation between the source layer 30 and the n-type deep layer 37 during manufacturing, the channel with high concentration formed on the side surface of the trench 14 and the n-type deep layer 37 are separated from each other. Since the relative positional relation is also shifted, there is a situation that the on-resistance tends to fluctuate greatly. On the other hand, in the MOSFET 10, since the entire side surface of the trench 14 can be used as a high-concentration channel, such fluctuation in on-resistance does not occur. Instead of the example shown in FIG. 2, the contact layers 32 may be distributed in the longitudinal direction of the trench 14 as shown in FIG. 10. Also in this example, it can be said that each contact layer 32 extends in a direction parallel to the longitudinal direction of the trench 14 when the semiconductor substrate 12 is viewed from above. Also, in this example, the source layer 30 may be provided between the contact layers 32.

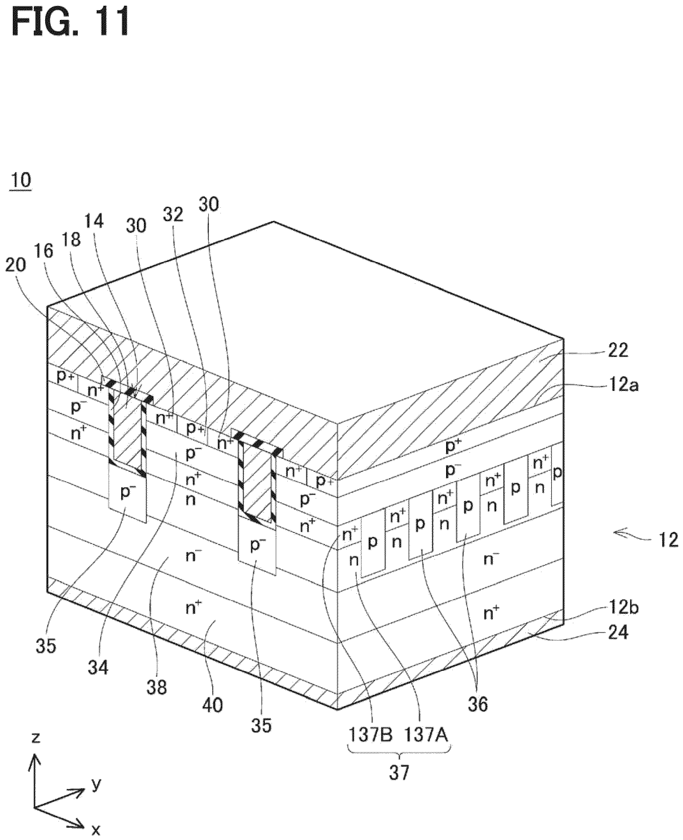

Further, in the MOSFET 10, as shown in FIG. 11, the n-type deep layer 37 may have an n-type deep lower layer 137A and an n-type deep upper layer 137B. The n-type deep lower layer 137A is arranged below the n-type deep upper layer 137B, and is an n-type layer having higher n-type impurity concentration than the drift layer 38, and has lower n-type impurity concentration than the n-type deep upper layer 137B. The n-type impurity concentration of the n-type deep lower layer 137A may be the same concentration as when configured with substantially a uniform concentration as described above. The n-type deep upper layer 137B is arranged between the n-type deep lower layer 137A and the body layer 34, and is arranged above the bottom surface of the trench 14. The n-type deep upper layer 137B is in contact with the gate insulating film 16 at the side surface of the trench 14 located below the body layer 34. When such an n-type deep upper layer 137B is provided, the depletion layer extending from both of the p-type trench lower layer 35 and the body layer 34 narrows the current path in the region between the p-type trench lower layer 35 and the body layer 34. A phenomenon (JFET effect) can be suppressed, and an increase in on-resistance can be suppressed. If the entire n-type deep layer 37 is configured to have a high concentration equivalent to that of the n-type deep upper layer 137B, the above-described effect of enhancing the breakdown voltage is reduced. When the n-type deep layer 37 includes the n-type deep lower layer 137A and the n-type deep upper layer 137B and the n-type deep upper layer 137B is arranged above the bottom surface of the trench 14, it is possible to suppress an increase in the on-resistance while satisfactorily enhancing the breakdown voltage.

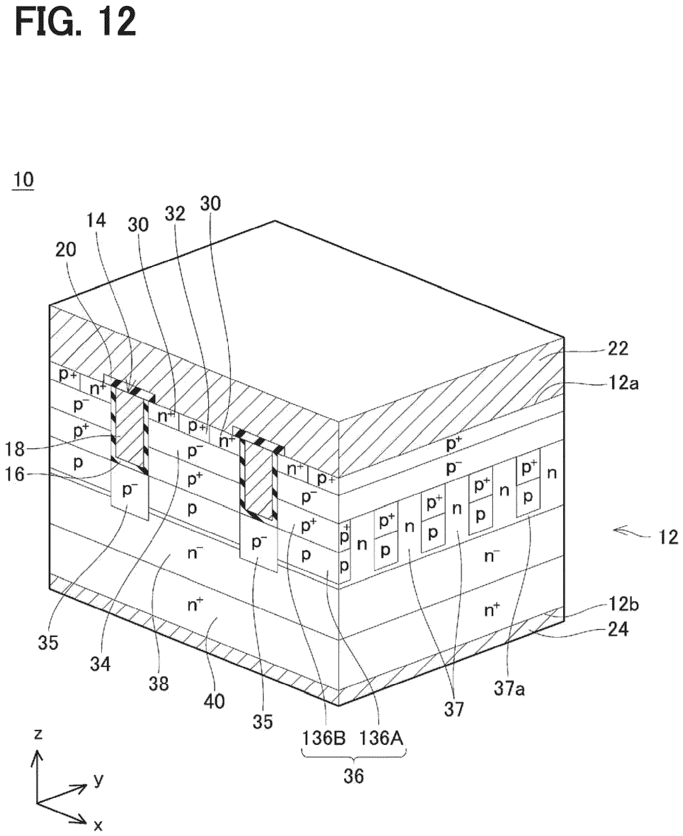

In the MOSFET 10, as shown in FIG. 12, the p-type deep layer 36 may have a p-type deep lower layer 136A and a p-type deep upper layer 136B. The p-type deep lower layer 136A is provided below the p-type deep upper layer 136B, and is a p-type layer having higher p-type impurity concentration than the body layer 34 and lower p-type impurity concentration than the p-type deep upper layer 136B. The p-type deep upper layer 136B is arranged between the p-type deep lower layer 136A and the body layer 34, and is arranged above the bottom surface of the trench 14. The p-type deep upper layer 136B is in contact with the gate insulating film 16 at the side surface of the trench 14 located below the body layer 34. In order to enhance the breakdown voltage of the MOSFET 10, it may be desirable that the concentration of the entire p-type deep layer 36 is high. However, there may be a concern about an increase in a leakage current as the damage during the ion implantation at the portion where the p-type deep layer 36 overlaps the p-type trench lower layer 35 increases. In the MOSFET 10 as shown in FIG. 12, by increasing the concentration of the p-type deep upper layer 136B at a portion where the p-type deep upper layer 136B does not overlap the p-type trench lower layer 35, it is possible to suppress an increase in the leakage current while enhancing the breakdown voltage.

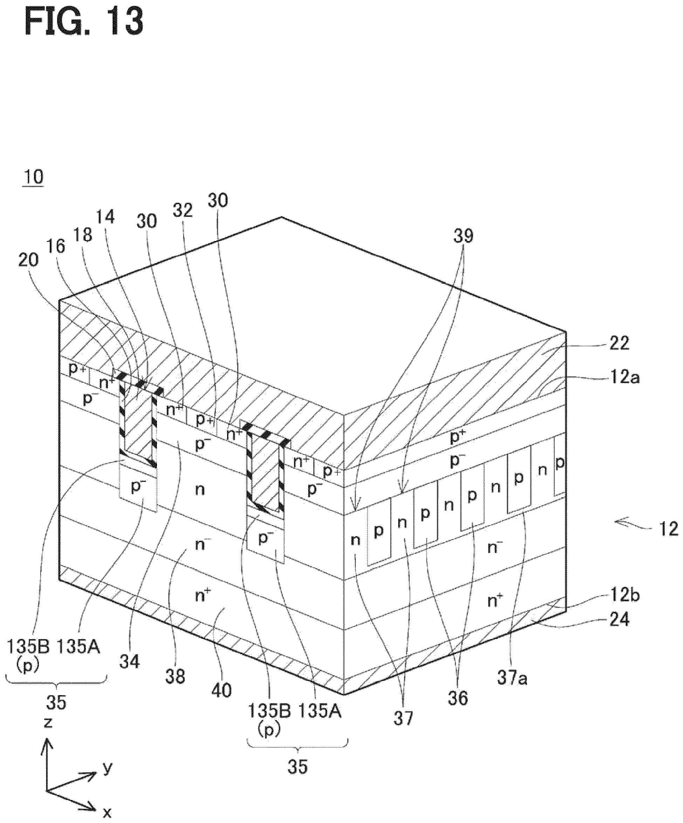

In the MOSFET 10, as shown in FIG. 13, the p-type trench lower layer 35 may have a first p-type trench lower layer 135A and a second p-type trench lower layer 135B. The first p-type trench lower layer 135A is provided below the second p-type trench lower layer 135B, and is a p-type layer with lower p-type impurity concentration than the second p-type trench lower layer 135B. The second p-type lower layer 135B is provided between the first p-type trench lower layer 135A and the trench 14, and is in contact with the gate insulating film 16 at the bottom surface of the trench 14. The thickness of the second p-type trench lower layer 135B in the depth direction, in other words, z-direction may be smaller than the thickness of the source layer 30 in the thickness direction. Although not particularly limited, the product of the p-type impurity concentration and thickness of the second p-type trench lower layer 135B may be greater than the product of the n-type impurity concentration and thickness of the n-type deep layer 37. If the second p-type trench lower layer 135B having high p-type impurity concentration is provided, the second p-type trench lower layer 135B will not be depleted when the MOSFET 10 is turned off. As a result, the capacitance, that is, the feedback capacitance between the gate electrode 18 and the drain electrode 24 decreases, and the switching speed of the MOSFET 10 can be enhanced.

A device with a large feedback capacitance may be required. In such a case, the relationship of p-type impurity concentration between the first p-type trench lower layer 135A and the second p-type trench lower layer 135B in FIG. 13 may be reversed. That is, the p-type impurity concentration of the second p-type trench lower layer 135B may be lower than the p-type impurity concentration of the first p-type trench lower layer 135A. Also in this case, the thickness of the second p-type trench lower layer 135B in the depth direction, in other words, z-direction may be smaller than the thickness of the source layer 30 in the thickness direction.

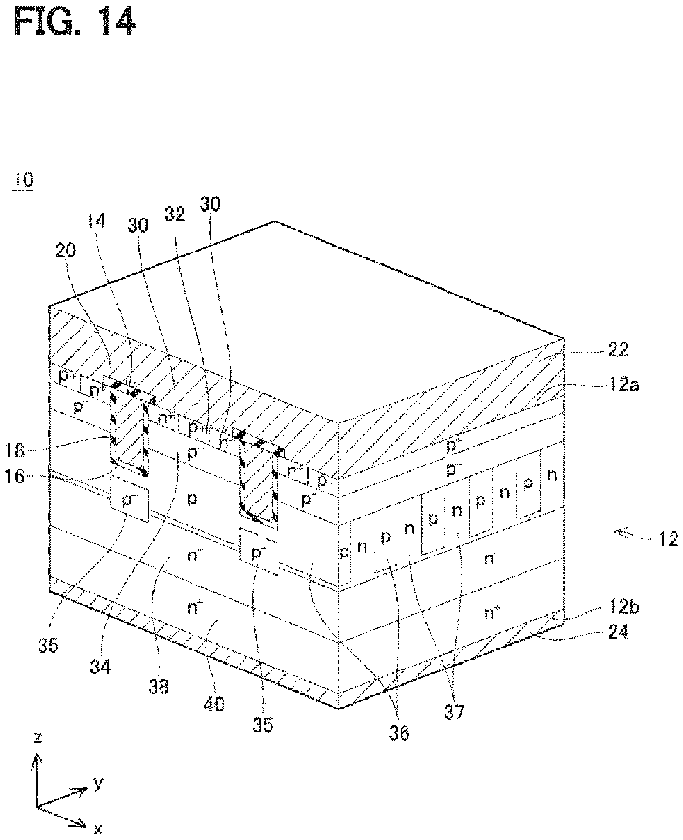

In the MOSFET 10, as shown in FIG. 14, the p-type trench lower layer 35 may be separated from the bottom surface of the trench 14. The distance between the p-type trench lower layer 35 and the bottom surface of the trench 14 may be smaller than the thickness of the source layer 30 in the thickness direction. Even though the p-type trench lower layer 35 is provided in such a positional relation, the effect of enhancing the breakdown voltage can be acquired. On the other hand, as will be described later in the manufacturing method, such a p-type trench lower layer 35 has a mode that reflects the result of decreasing the number of times of ion implantation for the body layer 34 that is simultaneously formed. That is, the MOSFET 10 shown in FIG. 14 has a structure that can be manufactured at lower cost.

Further, in each of the MOSFETs 10 described above, the depth of the n-type deep layer 37 is deeper than the depth of the p-type deep layer 36. Instead of this example, the depth of the n-type deep layer 37 may be equal to the depth of the p-type deep layer 36. Also, the depth of the n-type deep layer 37 may be smaller than the depth of the p-type deep layer 36.

In each of the MOSFETs 10 as described above, each of the n-type deep layers 37 has the connection region 37a extending directly below the adjacent p-type deep layer 36. Instead of this example, the n-type deep layer 37 may not have the connection region 37a.

In each of the MOSFETs 10 described above, the p-type deep layers 36 and the n-type deep layers 37 are perpendicular to the trenches 14 when the semiconductor substrate 12 is viewed from above. Instead of this example, the p-type deep layers 36 and the n-type deep layers 37 may obliquely intersect the trenches 14.

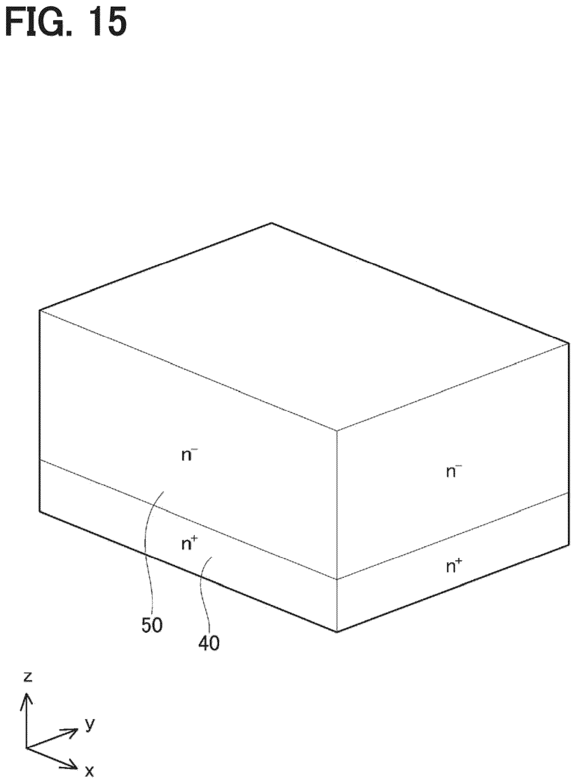

Next, a manufacturing method of the MOSFET 10 will be described. The MOSFET 10 is manufactured from a semiconductor substrate entirely constituted by the drain layer 40. First, as shown in FIG. 15, an epitaxial growth technique is used to form an n-type epitaxial layer 50 on the drain layer 40.

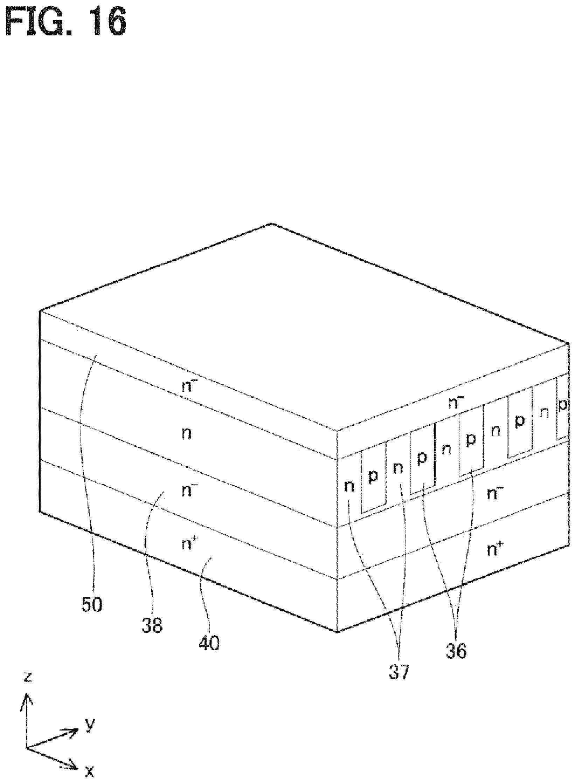

Next, as shown in FIG. 16, by adopting the ion implantation technique, the n-type deep layer 37 and the p-type deep layer 36 are formed by introducing the p-type impurities and the p-type impurities in a predetermined depth range apart from the surface of an epitaxial layer 50, as an example of a deep layer forming process. In particular, after introducing the n-type impurities from the surface toward a predetermined depth of the epitaxial layer 50, the p-type impurities are counter-doped through a mask toward a part of the range where the n-type impurities have been introduced. Thus, it is possible to form the n-type deep layer 37 and the p-type deep layer 36. Instead of this example, the n-type deep layer 37 and the p-type deep layer 36 may be formed by sequentially introducing the n-type impurities and the p-type impurities through masks respectively provided for the n-type deep layer 37 and the p-type deep layer 36. In addition, ion implantation for forming the n-type deep layer 37 can be omitted by previously adjusting the concentration of the n-type impurities to a depth corresponding to the formation range of the n-type deep layer 37 when the epitaxial layer 50 is epitaxially grown. When the n-type deep layer 37 or the p-type deep layer 36 is formed using the ion implantation technique or the epitaxial growth technique, it is possible to form the n-type deep lower layer 137A and the n-type deep upper layer 137B as shown in FIG. 11 or form the p-type deep lower layer 136A and the p-type deep upper layer 136B by changing the concentration in the depth direction, when the n-type deep layer 37 or the p-type deep layer 36 are formed by adopting the ion implantation technique or the epitaxial growth technique.

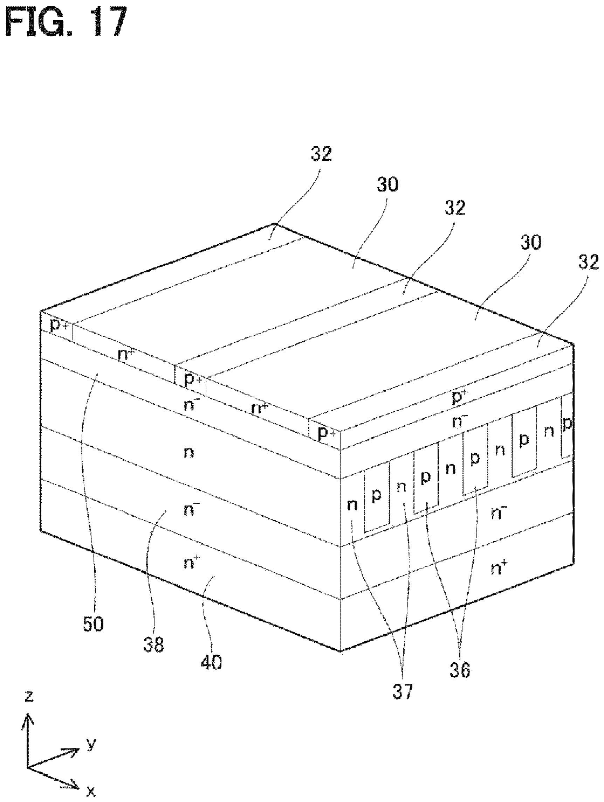

Next, as shown in FIG. 17, the source layer 30 and the contact layer 32 are formed by introducing the n-type impurities and the p-type impurities into the surface layer portion of the epitaxial layer 50 by adopting the ion implantation technique.

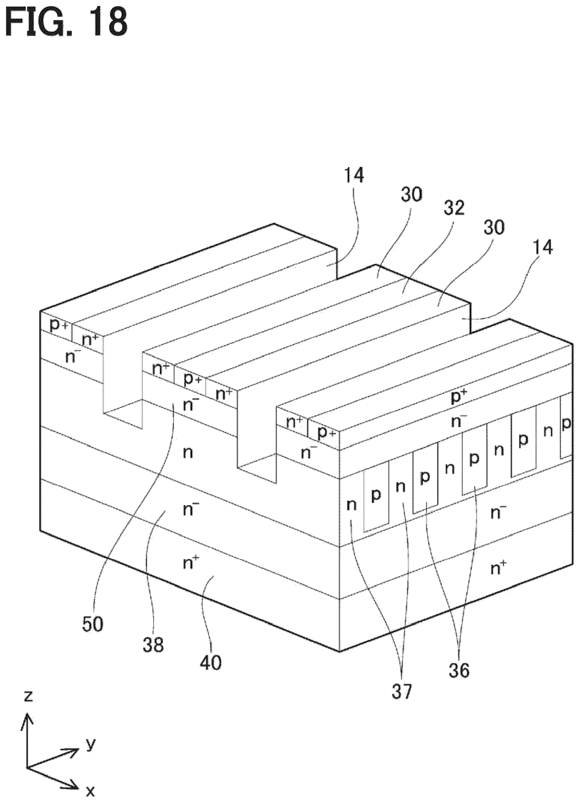

Next, as shown in FIG. 18, an etching technique is adopted to form the trenches 14 extending from the surface of the epitaxial layer 50 to the n-type deep layer 37 and the p-type deep layer 36, as an example of the trench forming process. The depth of trench 14 is adjusted so as not to exceed the n-type deep layer 37 and p-type deep layer 36. The trench 14 intersects the multiple p-type deep layers 36 and the multiple n-type deep layers 37 when the epitaxial layer 50 is viewed from above.

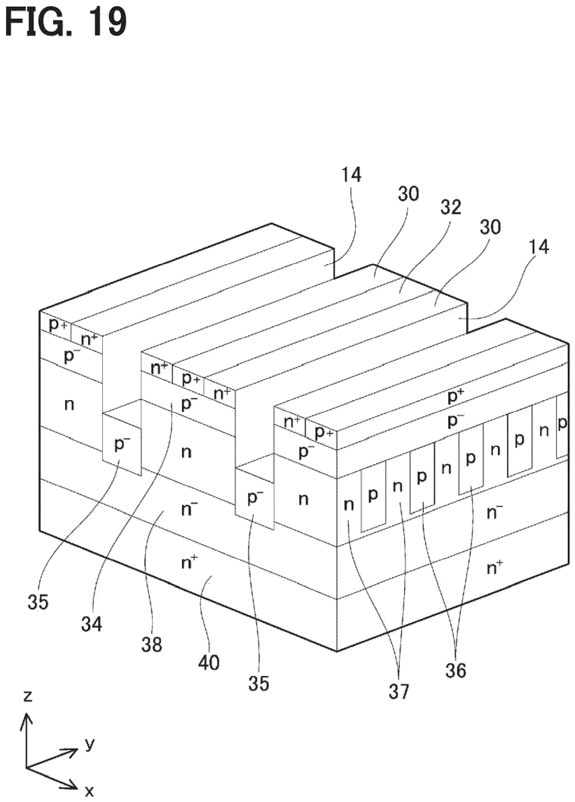

Next, as shown in FIG. 19, the body layer 34 and the p-type trench lower layer 35 are formed by introducing p-type impurities toward the surface of the epitaxial layer 50 in multiple stages by adopting the ion implantation technique, as an example of a body layer forming process and a p-type trench lower layer forming process. The body layer 34 is formed above the n-type deep layer 37 and the p-type deep layer 36 and below the source layer 30 and the contact layer 32. A p-type trench lower layer 35 is formed below the bottom surface of the trench 14. When the body layer 34 and the p-type trench lower layer 35 by adopting the ion implantation technique, it is possible to form the first p-type trench lower layer 135A and the second p-type trench lower layer 135B as illustrated in FIG. 13 by modifying the concentration in the depth direction. Furthermore, the depth to which the p-type impurity is introduced to form the second p-type trench lower layer 135B is limited to a range shallower than the source layer 30. Therefore, the p-type impurity concentration of the second p-type trench lower layer 135B can be freely set while the p-type impurity concentration of the body layer 34 is set to a desired value. Although the p-type impurities for forming the second p-type trench lower layer 135B are introduced to the source layer 30, the concentration of the n-type impurities included in the source layer 30 is higher than the concentration of the introduced p-type impurities. Therefore, the electrical characteristics of the MOSFET 10 does not greatly fluctuate. When the number of stages of ion implantation is adjusted so that the p-type impurities are selectively introduced in a region above the n-type deep layer 37 and the p-type deep layer 36 and below the source layer 30 and the contact layer 32, the p-type trench lower layer 35 is formed at a position apart from the bottom surface of the trench 14. The MOSFET 10 shown in FIG. 14 is an example manufactured by such a method. A soak prevention shielding film may be formed on the side surface of the trench 14 before the ion implantation of the p-type impurities.

Thereafter, the trenches 14, the gate insulating films 16, the gate electrodes 18, the interlayer insulating films 20, the source electrode 22, and the drain electrode 24 are formed. Accordingly, the MOSFET 10 is completed.

In the manufacturing method described above, after the formation of the epitaxial layer 50, it is possible to form a variety of semiconductor regions by adopting the ion implantation technique without executing a re-epitaxial growth process. In order to decrease the feedback capacitance, it may be desirable to form the n-type deep layer 37 and the p-type deep layer 36 deeply. However, it is difficult to form such a deep n-type deep layer 37 and p-type deep layer 36 at a predetermined depth in the epitaxial layer 50 by the ion implantation technique as in the above manufacturing method. For this reason, in a conventional example described in the background art, after forming a deep n-type deep layer and a p-type deep layer on the surface of the epitaxial layer by ion implantation, the re-epitaxial growth process is performed to form the body layer. However, the manufacturing method including the re-epitaxial growth process has an issue in an increasing cost. On the other hand, since the MOSFET 10 according to the present embodiment has the p-type trench lower layer 35, the feedback capacitance is low. Therefore, in the MOSFET 10 according to the present embodiment, a low feedback capacitance can be acquired without forming the n-type deep layer 37 and the p-type deep layer 36 deeply. Therefore, unlike the manufacturing method described above, the MOSFET 10 with a low feedback capacitance can be manufactured without performing the re-epitaxial process. Needless to say, the MOSFET 10 according to the present embodiment may be manufactured by carrying out the re-epitaxial growth process, if necessary.

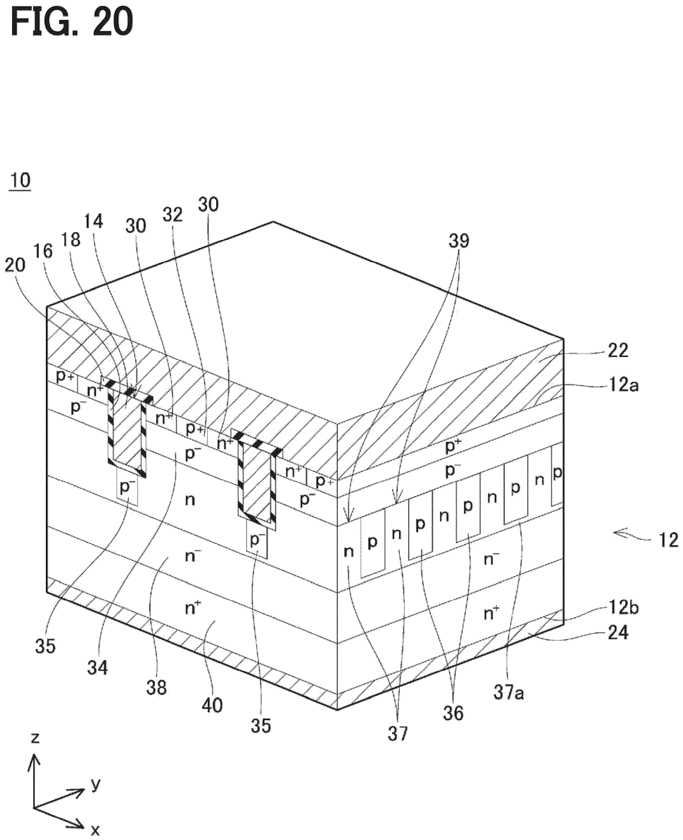

The MOSFET 10 described above is an example in which the body layer 34 and the p-type trench lower layer 35 are simultaneously formed adopting the ion implantation technique after forming the trench 14. Instead of this example, the p-type trench lower layer 35 and the p-type deep layer 36 may be formed simultaneously before forming the trench 14. In this case, the body layer 34 is formed by another ion implantation process. FIG. 20 shows a MOSFET 10 in which a p-type trench lower layer 35 and a p-type deep layer 36 are formed at the same time.

In this MOSFET 10, the width of the p-type trench lower layer 35 is shorter than the width of the trench 14 when measured along the lateral direction of the trench 14, in other words, the x-direction. As a result, since it is possible to allow a slight misalignment between the p-type trench lower layer 35 and the trench 14, it is possible to arrange the p-type trench lower layer 35 to be in contact with only the bottom surface of the trench 14 when forming the trench 14.

The features of the technology disclosed in the present disclosure are summarized below. It should be noted that the technical elements described below are independent technical elements and exhibit technical usefulness alone or in various combinations, and are not limited to the combinations described in the claims at the time of filing.

A field effect transistor disclosed in the present specification includes a semiconductor substrate having a trench on an upper surface thereof, a gate insulating film covering an inner surface of the trench, and a gate electrode disposed in the trench and being insulated from the semiconductor substrate by the gate insulating film. The material of the semiconductor substrate is not particularly limited, but may be, for example, a silicon carbide. The semiconductor substrate includes an n-type source layer, a p-type body layer, a p-type trench lower layer, multiple p-type deep layer, and multiple n-type deep layers. The source layer is in contact with the gate insulating film at a side surface of the trench. The body layer is in contact with the gate insulating film at the side surface of the trench located below the source layer. The trench lower layer is located below the trench, and extends in a longitudinal direction when the semiconductor substrate is viewed from above. Each of the p-type deep layers protrudes downward from the body layer, extends from the body layer to a position below a bottom surface of the trench, extends along a first direction intersecting the trench when the semiconductor substrate is viewed from above, is disposed to have a spacing portion therebetween in a second direction orthogonal to the first direction when the semiconductor substrate is viewed from above, and is in contact with the trench lower layer located below the trench. Each of the plurality of n-type deep layers is disposed in the corresponding spacing portion and is in contact with the gate insulating film on the side surface of the trench located below the body layer.

In the field effect transistor described above, the source layer may extend in a direction parallel to the longitudinal direction of the trench when the semiconductor substrate is viewed from above. In this field effect transistor, the fluctuation of the on-resistance is suppressed.

In the field effect transistor described above, the semiconductor substrate may have a contact layer that is provided on the body layer and has a p-type impurity concentration higher than the body layer. In this case, the contact layer may extend in a direction parallel to the longitudinal direction of the trench when the semiconductor substrate is viewed from above.

In the field effect transistor described above, the p-type trench lower layer may protrude below the p-type deep layers. The above-described field effect transistor can have a high breakdown voltage.

In the field effect transistor described above, the p-type trench lower layer may be shallower than each of the p-type deep layers. This field effect transistor can have a lower on-resistance.

In the field effect transistor described above, the semiconductor substrate may further include a drift layer arranged below each of the n-type deep layers and having an n-type impurity concentration lower than each of the n-type deep layers. In other words, each of the n-type deep layers may have a higher n-type impurity concentration than the drift layer. This field effect transistor can have a lower on-resistance.

In the field effect transistor described above, each of the n-type deep layers may have an n-type deep lower layer and an n-type deep upper layer. The n-type deep upper layer is disposed above the n-type deep lower layer and has an n-type impurity concentration higher than the n-type deep lower layer. In this case, the n-type deep upper layer is arranged above the bottom surface of the trench. This field effect transistor can achieve both high breakdown voltage and low on-resistance.

In the field effect transistor described above, each of the p-type deep layers may have a p-type deep lower layer and a p-type deep upper layer. The p-type deep upper layer is arranged above the p-type deep lower layer, and has higher p-type impurity concentration than the p-type deep lower layer. In this case, the p-type deep upper layer is arranged above the bottom surface of the trench. This field effect transistor can have a high breakdown voltage while suppressing an increase in leakage current.

In the field effect transistor described above, the depth from the bottom surface of the corresponding trench to the lower surface of each p-type trench lower layer may match the depth from the upper surface of the semiconductor substrate to the lower surface of the body layer. This field effect transistor has a form reflecting the result of simultaneous formation of the p-type trench lower layer and the body layer. This field effect transistor has a structure that can be manufactured at lower cost.

In the field effect transistor described above, the p-type trench lower layer may be separated from the bottom surface of the trench. This field effect transistor has a form reflecting the result of reducing the number of times of ion implantation of the body layer formed at the same time. This field effect transistor has a structure that can be manufactured at lower cost.

In the above-mentioned field effect transistor described above, the p-type trench lower layer may have multiple portions that are different in the amount of concentration in the depth direction. The p-type trench lower layer may have a first p-type trench lower layer and a second p-type trench lower layer arranged above the first p-type trench lower layer. The second p-type trench lower layer may have a higher concentration than the first p-type trench lower layer, and may have a lower concentration than the first p-type trench lower layer. The thickness of the second p-type trench lower layer in the depth direction may be smaller than the thickness of the source layer in the depth direction. The feedback capacitance can be adjusted by adjusting the impurity concentration of the p-type trench lower layer.

In the field effect transistor described above, the p-type trench lower layer may be formed into several segments separated from each other in the longitudinal direction of the trench. Each of the p-type deep layers may pass through a portion between corresponding adjacent two of the segments of the p-type trench lower layer. This field effect transistor suppresses an increase in leakage current.

In the field effect transistor described above, the multiple n-type deep layers may extend from the lower surface of the body layer to a position below the lower surface of each of the multiple p-type deep layers.

In the field effect transistor, the first direction may be orthogonal to the trench when the semiconductor substrate is viewed from above.

A method of manufacturing a field effect transistor described in the present specification includes a deep layer forming process, a trench forming process, a body layer forming process, and a p-type trench lower layer forming process. The deep layer forming process includes formation of multiple p-type deep layers and multiple n-type deep layers at an n-type epitaxial layer. Each of the multiple p-type deep layers extends in a first direction in a top view of the epitaxial layer. The multiple p-type deep layers are spaced in intervals in a second direction perpendicular to the first direction in the top view of the epitaxial layer. The multiple n-type deep layers are correspondingly located in the intervals. The trench forming process includes formation of a trench having a depth from a surface of the epitaxial layer to a location not exceeding a depth of each of the multiple p-type deep layers and a depth of each of the multiple n-type deep layers. The trench intersects the multiple p-type deep layers and the multiple n-type deep layers in the top view of the epitaxial layer. The body layer forming process includes formation of a body layer above the multiple p-type deep layers and the multiple n-type deep layers through ion implantation introducing p-type impurities toward a surface of the epitaxial layer. The p-type trench lower layer forming process includes formation of a p-type trench lower layer below a bottom surface of the trench through the ion implantation.

In the deep layer forming process, the ion implantation may be adopted to form the multiple p-type deep layers and the multiple n-type deep layers by introducing the p-type impurities and the n-type impurities in a predetermined depth range apart from the surface of the epitaxial layer. According to this manufacturing method, a field effect transistor can be manufactured without executing the re-epitaxial growth process.

The body layer forming process and the p-type trench lower layer forming process may be performed at the same time after the trench forming process. According to the method described above, it is possible to manufacture the field effect transistor with lower cost.

The manufacturing method may further include a source layer forming process of introducing n-type impurities into an upper layer portion of the epitaxial layer to form a source layer through the ion implantation. In this case, the p-type trench lower layer may have a first p-type trench lower layer and a second p-type trench lower layer arranged above the first p-type trench lower layer. The second p-type trench lower layer may have higher concentration than the first p-type trench lower layer, and may have lower concentration than the first p-type trench lower layer. The thickness of the second p-type trench lower layer in the depth direction may be smaller than the thickness of the source layer in the depth direction. According to this manufacturing method, by adjusting the impurity concentration of the p-type trench lower layer, a field effect transistor with an adjusted feedback capacitance can be manufactured.

The p-type trench lower layer forming process may be performed before the trench forming process. In this case, the width of the p-type trench lower layer may be smaller than the width of the trench. According to this manufacturing method, a slight misalignment between the p-type trench lower layer and the trench can be allowed.

The p-type trench lower layer forming process may be performed along with a process of forming the multiple p-type deep layers included in the deep layer forming process at the same time. According to the method described above, it is possible to manufacture the field effect transistor with lower cost.

Although the embodiments have been described in detail above, these are merely examples and do not limit the scope of claims. The techniques described in the claims include various modifications of the specific examples illustrated above. The technical elements described in the present specification or the drawings exhibit technical usefulness alone or in various combinations, and are not limited to the combinations described in the claims at the time of filing. In addition, the techniques illustrated in the present specification or drawings achieve a plurality of objectives at the same time, and achieving one of the objectives itself has technical usefulness.

## Claims

1. Afield effect transistor (10) comprising:
a semiconductor substrate (12) having a trench (14) at an upper surface of the semiconductor substrate;
a gate insulating film (16) covering an inner surface of the trench; and
a gate electrode (18) located inside the trench, the gate electrode being insulated from the semiconductor substrate through the gate insulating film, wherein
the semiconductor substrate includes:
an n-type source layer (30) being in contact with the gate insulating film at a side surface of the trench;
a p-type body layer (34) being in contact with the gate insulating film at the side surface of the trench below the n-type source layer;
a p-type trench lower layer (35) located below the n-type source layer and extending in a longitudinal direction of the trench in a top view of the semiconductor substrate;
a plurality of p-type deep layers (36); and
a plurality of n-type deep layers (37),
each of the plurality of p-type deep layers protrudes and extends downward from the p-type body layer to a location below a bottom surface of the trench,
each of the plurality of p-type deep layers extends in a first direction intersecting the trench in the top view of the semiconductor substrate,
the plurality of p-type deep layers are spaced at intervals in a second direction perpendicular to the first direction in the top view of the semiconductor substrate, and are in contact with the p-type trench lower layer located below the trench, and
each of the plurality of n-type deep layers is located in a corresponding one of the intervals, and is in contact with the gate insulating film at the side surface of the trench located below the p-type body layer.

2. The field effect transistor according to Claim 1,
wherein the n-type source layer extends in a direction parallel to the longitudinal direction of the trench in the top view of the semiconductor substrate.

3. The field effect transistor according to Claim 1 or 2, wherein
the semiconductor substrate further includes a contact layer (32) located above the p-type body layer and having a p-type impurity concentration being higher than the p-type body layer, and
the contact layer extends in a direction parallel to the longitudinal direction of the trench in the top view of the semiconductor substrate.

4. The field effect transistor according to any one of Claims 1 to 3, wherein
each of the n-type deep layers includes:
an n-type deep lower layer (137A); and
an n-type deep upper layer (137B) located above the n-type deep lower layer, the n-type deep upper layer having an n-type impurity concentration being higher than in the n-type deep lower layer, and
the n-type deep upper layer is located above the bottom surface of the trench.

5. The field effect transistor according to any one of Claims 1 to 4, wherein
each of the plurality of p-type deep layers includes:
a p-type deep lower layer (136A); and
a p-type deep upper layer (136B) located above the p-type deep lower layer, and
the p-type deep upper layer is located above the bottom surface of the trench.

6. The field effect transistor according to any one of Claims 1 to 5,
wherein a depth from the bottom surface of the trench to a lower surface of the p-type trench lower layer is identical to a depth from the upper surface of the semiconductor substrate to a lower surface of the p-type body layer.

7. The field effect transistor according to Claim 6,
wherein the p-type trench lower layer is separated from the bottom surface of the trench.

8. The field effect transistor according to Claim 6, wherein
the p-type trench lower layer has a plurality of portions in a depth direction, and
the plurality of portions have different concentration.

9. The field effect transistor according to Claim 8, wherein
the p-type trench lower layer includes:
a first p-type trench lower layer (135A); and
a second p-type trench lower layer (135B) located above the first p-type trench lower layer, and
the second p-type trench lower layer has a concentration being higher than in the first p-type trench lower layer.

10. The field effect transistor according to Claim 8, wherein
the p-type trench lower layer includes:
a first p-type trench lower layer (135A); and
a second p-type trench lower layer (135B) located above the first p-type trench lower layer, and
the second p-type trench lower layer has a concentration being lower than the first p-type trench lower layer.

11. The field effect transistor according to Claim 9 or 10,
wherein a thickness of the second p-type trench lower layer in a depth direction of the second p-type trench lower layer is smaller than a thickness of the n-type source layer in a depth direction of the n-type source layer.

12. The field effect transistor according to any one of Claims 1 to 11, wherein
the p-type trench lower layer has a plurality of segments separated from each other in the longitudinal direction of the trench, and
each of the plurality of p-type deep layers extends through a portion between corresponding adjacent two of the plurality of segments.

13. A method of manufacturing a field effect transistor (10), the method comprising:
a deep layer forming process including forming a plurality of p-type deep layers (36) and a plurality of n-type deep layers (37, 137) at an n-type epitaxial layer (50), the plurality of p-type deep layers extending in a first direction in a top view of the n-type epitaxial layer, the plurality of p-type deep layers being spaced at intervals in a second direction perpendicular to the first direction in the top view of the n-type epitaxial layer, the plurality of n-type deep layers correspondingly located in the intervals;
a trench forming process including forming a trench (14) having a depth from a surface of the n-type epitaxial layer to a location not exceeding a depth of each of the plurality of p-type deep layers and a depth of each of the plurality of n-type deep layers, the trench intersecting the plurality of p-type deep layers and the plurality of n-type deep layers in the top view of the n-type epitaxial layer;
a body layer forming process including
forming a body layer (34) above the plurality of p-type deep layers and the plurality of n-type deep layers through ion implantation introducing p-type impurities to a surface of the n-type epitaxial layer; and
a p-type trench lower layer forming process including forming a p-type trench lower layer (35) below a bottom surface of the trench through ion implantation.

14. The method according to Claim 13,
wherein the deep layer forming process further includes forming the plurality of p-type deep layers and the plurality of n-type deep layers by introducing n-type impurities and the p-type impurities to a predetermined depth range apart from the surface of the n-type epitaxial layer through ion implantation.

15. The method according to Claim 13 or 14,
wherein the body layer forming process and the p-type trench lower layer forming process are executed concurrently after the trench forming process.

16. The method according to Claim 15, further comprising:
a source layer forming process including
forming a source layer (30) through ion implantation introducing n-type impurities to an upper layer portion of the n-type epitaxial layer, wherein
the p-type trench lower layer includes:
a first p-type trench lower layer (135A); and
a second p-type trench lower layer (135B) located above the first p-type trench lower layer,
the second p-type trench lower layer has a concentration being larger than the first p-type trench lower layer, and
a thickness of the second p-type trench lower layer in a depth direction of the second p-type trench lower layer is smaller than a thickness of the source layer in a depth direction of the source layer.

17. The method according to Claim 15, further comprising:
a source layer forming process including
forming a source layer (30) through ion implantation introducing n-type impurities to an upper layer portion of the n-type epitaxial layer, wherein
the p-type trench lower layer includes:
a first p-type trench lower layer (135A); and
a second p-type trench lower layer (135B) located above the first p-type trench lower layer,
the second p-type trench lower layer has a concentration being smaller than in the first p-type trench lower layer, and
a thickness of the second p-type trench lower layer in a depth direction of the second p-type trench lower layer is smaller than a thickness of the source layer in a depth direction of the source layer.

18. The method according to Claim 13 or 14, wherein
the p-type trench lower layer form ing process is executed before the trench forming process, and
a width of the p-type trench lower layer is smaller than a width of the trench.

19. The method according to Claim 18,
wherein the p-type trench lower layer forming process and the forming of the plurality of p-type deep layers included in the deep layer forming process are executed concurrently.
